Europäisches Patentamt

European Patent Office

Office européen des brevets

(19)

(11) Veröffentlichungsnummer: **0 062 300**
**A2**

(12) **EUROPÄISCHE PATENTANMELDUNG**

(21) Anmeldenummer: 82102745.5

(22) Anmeldetag: 31.03.82

(51) Int. Cl.³: **H 05 K 3/02, H 05 K 3/24,**
**H 05 K 3/42**

(30) Priorität: 06.04.81 DE 3113855

(43) Veröffentlichungstag der Anmeldung: 13.10.82
Patentblatt 82/41

(84) Benannte Vertragsstaaten: DE FR GB IT

(71) Anmelder: **FRITZ WITTIG Herstellung gedruckter**
**Schaltungen, Konrad-Celtis-Strasse 81,**
**D-8000 München 70 (DE)**

(72) Erfinder: **Baumann, Klaus, Fliederweg 1,**
**D-8000 München 90 (DE)**

(74) Vertreter: **Ebbinghaus, Dieter et al, K.L. Schiff Dr. A. von**
**Funer Dipl.-Ing. P. Strehl Dr. U. Schübel-Hopf Dipl.-Ing.**
**D. Ebbinghaus Dr. Ing. D. Finck Patentanwälte**
**Mariahilfplatz 2 & 3, D-8000 München 90 (DE)**

(54) Verfahren und Herstellung von Leiterplatten.

(57) Es ist ein Verfahren zur Herstellung von Leiterplatten beschrieben, bei dem statt der üblichen Fotobehandlung oder Siebdruck zur Bildung des Leiterbahnenmusters auf die durchgehende Kupferschicht 6 des
Rohlings eine Ätzresistschicht 8 aufgebracht wird. Die
Ätzresistschicht 8 wird entsprechend dem gewünschten
Leiterbahnenmuster mittels eines Laserstrahls verdampft
und die verbleibende Kupferschicht an den durch die
Laserbehandlung entfernten Stellen bis zur Oberfläche
der Kunststoffplatte 1 weggeätzt.

## VERFAHREN ZUR HERSTELLUNG VON LEITERPLATTEN

Die Erfindung bezieht sich auf ein Verfahren zur Herstellung von Leiterplatten, bei dem auf eine Kunststoffplatte oder -folie zumindest einseitig eine Kupferschicht aufgebracht und danach das Leiterbahnenmuster in der Kupferschicht gebildet wird.

Herkömmlicherweise werden bei der Herstellung von Leiterplatten die beidseitig mit einer Kupferkaschierung angelieferten Kunststoffplatten nach dem Bohren der Durchgangsbohrungen mit einer schwachen Kupferschicht überzogen, die die Kupferkaschierung und die Oberfläche der Durchgangsbohrungen bedeckt. Auf die so gebildete Kupferschicht wird eine Fotoresistschicht aufgewalzt. Hierauf wird auf die Fotoresistschicht die Strichmaske aufgelegt, belichtet und nach dem Entfernen der Maske die Fotoresistschicht entwickelt, wobei die für eine weitere Kupferbeschichtung freibleibenden Oberflächenbereiche der Kunststoffplatte von der Fotoresistschicht befreit werden. Es verbleiben die gewünschten Leiterbahnen und Bohrungen der Leiterplatte. Die Leiterbahnen werden anschließend galvanisch verstärkt und z.B. in einem Zinnbad mit Zinn galvanisiert.

Die bekannte Art der Herstellung von Leiterplatten ist verhältnismäßig arbeitsaufwendig. Insbesondere aber ist die Leiterbahnendichte, da das Eindringen von Staubteilchen in der Fertigung praktisch unvermeidbar ist, verhältnismäßig gering. Treibt man nach dem bekannten Herstellungsverfahren die Leiterbahnendichte über ein bestimmtes Höchstmaß hinaus, so kommt es wegen der unvermeidlichen Staubteilchen zu Kurzschlüssen zwischen einzelnen Leiterbahnen, Einschnürungen oder Unterbrechungen und damit zu einem wirtschaftlich nicht mehr zu vertretenden Ausschußanteil.

Der Erfindung liegt daher die Aufgabe zugrunde, ein Verfahren zur Herstellung von Leiterplatten anzugeben, das eine weitere Erhöhung der zulässigen Leiterdichte ermöglicht.

Diese Aufgabe wird erfindungsgemäß dadurch gelöst, daß zur Ausbildung des Leiterbahnenmusters eine Ätzresistschicht auf die Kupferschicht aufgebracht wird, die Ätzresistschicht entsprechend dem gewünschten Leiterbahnenmuster mittels eines Laserstrahls selektiv verdampft und die verbleibende Kupferschicht an den durch die Laserbehandlung entfernten Stellen bis zur Oberfläche der Kunststoffplatte weggeätzt wird.

Da bei dem erfindungsgemäßen Vorgehen der als Schneidwerkzeug dienende Laserstrahl sehr scharf gebündelt werden kann, kann der Abstand zwischen den einzelnen Leiterbahnen sehr gering gehalten werden. Auf der durch den Laserstrahl aufzuschneidenden Ätzresistschicht liegende Staubpartikel werden durch den Laserstrahl weggebrannt. Die Leiterbahnendichte läßt sich daher beträchtlich erhöhen. Während bisher bei einem Raster von 2,54 mm und einer Augengröße von ca. 1,5 mm zwischen zwei Bauteilanschlüssen zwei bis drei Leiterbahnen hindurchgeführt werden konnten, lassen sich bei Anwendung des erfindungsgemäßen Verfahrens zwischen zwei Bauteilanschlüssen entsprechend bis zu acht Leiterbahnen hindurchführen. Dabei entsteht weniger Ausschuß als bisher, da sich das Leiterbild bei Steuerung mittels eines Rechners vollautomatisch erstellen läßt. Hinzu kommt, daß der gesamte Fotoprozeß entfällt, der einen Hauptkostenfaktor an Personal und Material des bekannten Verfahrens darstellt. Bei Anwendung des erfindungsgemäßen Verfahrens läßt sich dagegen bei entsprechender Software das Leiterbild direkt aus dem CAD (computer aided design)-Speicher auf die Platte übertragen. Zwischenträger und Werkzeuge wie Druckvorlagen und Filme sind nicht mehr notwendig. Wegen der größeren Packungsdichte läßt sich auch ein beträchtlicher Rückgang des Multilayeranteils bzw. der Lagenzahl verwirklichen, wodurch sich weitere Kosteneinsparungen ergeben. Schließlich läßt sich bei Anwendung des erfindungsgemäßen Verfahrens der Kupferverbrauch beträchtlich verringern, da die einzelnen Kupferschichten wesentlich dünner ausgeführt werden können, und nicht mehr soviel Fläche abgeätzt wird.

Nach dem erfindungsgemäßen Verfahren lassen sich bei der Herstellung von Multilayer-Platten die Innenlagen herstellen.

Gemäß einer bevorzugten Weiterbildung des erfindungsgemäßen Verfahrens wird bei - an sich üblicher - beidseitiger Kupferbeschichtung der Kunststoffplatte nach dem Bohren der Durchgangslöcher und dem Vorverkupfern der Oberfläche der Durchgangslöcher auf die verstärkte Kaschierung eine Lackschicht aufgetragen, worauf die Kupferschicht in den Durchgangslöchern verstärkt wird. Bei Multilayer-Platten wird erst nach der Zusammenstellung sämtlicher Platten gebohrt.

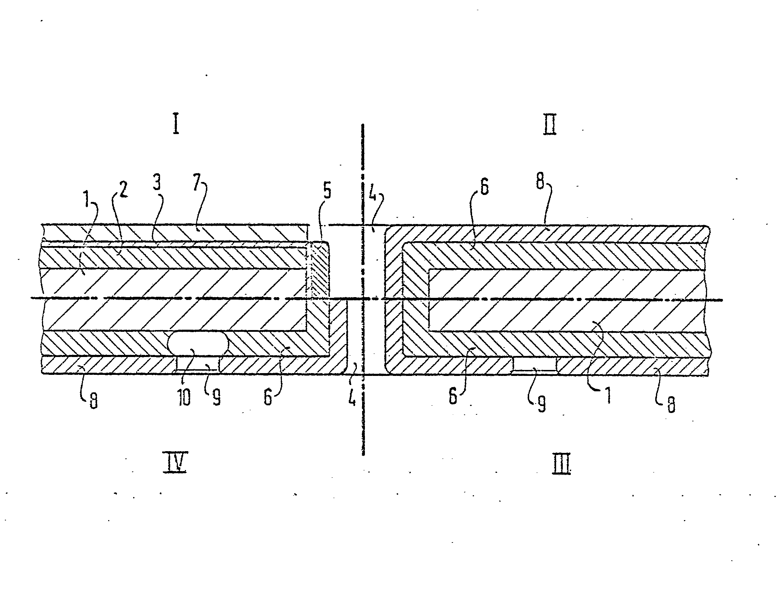

Die Erfindung wird im folgenden durch ein Ausführungsbeispiel anhand der Zeichnung näher erläutert. Die Zeichnung zeigt den schematischen Querschnitt einer Leiterplatte während verschiedener Phasen der Herstellung.

Die Leiterplatte 1 wird mit einer etwa 5 bis 12 μm starken Kupferkaschierung 2 angeliefert (Quadrant I). Nach dem Bohren der Durchgangslöcher 4 wird, wie ebenfalls im Quadrant I gezeigt, auf die Kupferkaschierung 2 in einem chemischen und anschließenden galvanischen Arbeitsgang eine 5 bis 7 μm dicke Verkupferungsschicht 3 aufgetragen. Die Verkupferungsschicht 3 wird darauf mittels einer Lackschicht 7 abgedeckt und die Oberfläche in der Durchgangsbohrung 4 galvanisch mit einer Verstärkungsschicht 5 von 25 bis 30 μm Dicke versehen. Die Lackschicht 7 wird anschließend wieder entfernt. Das Ergebnis ist eine Kunststoffplatte 1 mit einer durchgehenden Kupferschicht 6 (Quadranten II, III und IV).

Auf die Kupferschicht 6 wird nun eine beispielsweise aus Pb-Sn bestehende Ätzresistschicht 8 aufgetragen (Quadrant II) und dann umgeschmolzen. Die Schmelztemperatur der Ätzresistschicht 8 darf die üblicherweise angewandte Löttemperatur nicht überschreiten. Anschließend wird die Ätzresistschicht längs vorgegebener Bahnen mittels eines Laserstrahls verdampft. Hierzu wird der Laserkopf oder der Werkstücktisch der Bearbeitungsvorrichtung, gesteuert von einem Rechner, entsprechend den gewünschten Bahnen geführt. Als Programmspeicher kann hierbei der Speicher des Rechners selbst oder ein Band- oder Plattenspeicher dienen.

Eine trägheitsfreie und damit noch schnellere Bearbeitung ist möglich, wenn statt des Laserkopfes oder des Werkstücktisches mittels Ablenksystemen der Laserstrahl selbst längs den gewünschten Bahnen gelenkt wird.

Nach dem partiellen Verdampfen der Ätzresistschicht 8, wobei der in den Quadranten III und IV gezeigte Kanal 9 entsteht, wird die Leiterplatte schließlich bis hinab zur Oberfläche der Kunststoffplatte 1 geätzt, wobei, getrennt durch die Ätzung 10, die einzelnen Leiterbahnen der Leiterplatte entstehen.Anschließend wird der Ätzresist durch Strippen vollständig (Oberfläche und Bohrungen) entfernt,und ein Lötstop-Resist in Siebdruck- oder Fototechnik aufgebracht. Anschließend werden die Augen und Durchgangslöcher mittels des Heißluft-Verzinnungsverfahrens (Hot Air Levelling) verzinnt. Die Leiterplatte ist damit, bis auf die übliche Endbehandlung, fertig.

Patentansprüche

1. Verfahren zur Herstellung von Leiterplatten, bei dem auf einen Kunststoffträger (1) zumindest einseitig eine Kupferschicht (6) aufgebracht und danach das Leiterbahnenmuster in der Kupferschicht (6) gebildet wird, dadurch gekennzeichnet , daß zur Ausbildung des Leiterbahnenmusters eine metallische Ätzresistschicht (8) auf die Kupferschicht (6) aufgebracht wird, die Ätzresistschicht (8) entsprechend dem gewünschten Leiterbahnenmuster mittels eines Laserstrahls selektiv verdampft und die verbleibende Kupferschicht (6) an den durch die Laserbehandlung entfernten Stellen (Kanal 9) bis zur Oberfläche der Kunststoffplatte (1) weggeätzt wird.

2. Verfahren nach Anspruch 1, dadurch gekennzeichnet , daß bei beidseitiger Kupferbeschichtung des Kunststoffträgers (1) nach dem Bohren der Durchgangslöcher (4) und dem Vorverkupfern der Oberfläche der Durchgangslöcher auf die Kupferschicht (6) eine Lackschicht (7) aufgetragen wird, worauf die Kupferschicht in den Durchgangslöchern (4) verstärkt wird.

1/1

I    II

IV    III